(19) Europäisches Patentamt / European Patent Office / Office européen des brevets

(11) **EP 3 671 844 B1**

(12) **FASCICULE DE BREVET EUROPEEN**

(45) Date de publication et mention de la délivrance du brevet:
**02.10.2024 Bulletin 2024/40**

(21) Numéro de dépôt: **19216886.2**

(22) Date de dépôt: **17.12.2019**

(51) Classification Internationale des Brevets (IPC):
*H10B 63/00* (2023.01)   *H10B 53/00* (2023.01)
*H10N 70/00* (2023.01)   *H10N 70/20* (2023.01)

(52) Classification Coopérative des Brevets (CPC):
**H10B 63/80; H10B 53/00; H10B 63/30;
H10N 70/043; H10N 70/24; H10N 70/245;
H10N 70/826; H10N 70/8833**

(54) **PROCEDE DE FABRICATION D'UNE MEMOIRE FERROELECTRIQUE ET PROCEDE DE CO-FABRICATION D'UNE MEMOIRE FERROELECTRIQUE ET D'UNE MEMOIRE RESISTIVE ET DISPOSITIF RESULTANT**

HERSTELLUNGSVERFAHREN EINES FERROELEKTRISCHEN SPEICHERS UND VERFAHREN ZUR GLEICHZEITIGEN HERSTELLUNG EINES FERROELEKTRISCHEN UND EINES RESISTIVEN SPEICHERS UND DARAUS ENTSTEHENDE VORRICHTUNG

METHOD FOR MANUFACTURING A FERROELECTRIC MEMORY AND METHOD FOR JOINT MANUFACTURING OF A FERROELECTRIC MEMORY AND A RESISTIVE MEMORY AND RESULTING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2018 FR 1873162**

(43) Date de publication de la demande:
**24.06.2020 Bulletin 2020/26**

(73) Titulaire: **Commissariat à l'Energie Atomique et aux Energies Alternatives
75015 Paris (FR)**

(72) Inventeurs:
• **GRENOUILLET, Laurent
38054 Grenoble Cedex 09 (FR)**
• **CHARPIN-NICOLLE, Christelle
38054 Grenoble Cedex 09 (FR)**
• **COIGNUS, Jean
38054 Grenoble Cedex 09 (FR)**
• **FRANCOIS, Terry
38054 Grenoble Cedex 09 (FR)**
• **KERDILES, Sébastien
38054 Grenoble Cedex 09 (FR)**

(74) Mandataire: **Cabinet Camus Lebkiri
25 rue de Maubeuge
75009 Paris (FR)**

(56) Documents cités:
**WO-A2-2010/035980     CN-A- 103 165 172
US-A1- 2016 005 749     US-A1- 2018 265 967
US-A1- 2018 269 057     US-A1- 2018 358 471**

**Description**

**DOMAINE TECHNIQUE DE L'INVENTION**

Le domaine technique de l'invention est celui de la fabrication de mémoires ferroélectriques et plus particulièrement celui de la fabrication de mémoires ferroélectriques ayant une couche de matériau actif en dioxyde d'hafnium et de la co-intégration d'une telle mémoire ferroélectrique avec une mémoire résistive.

La présente invention concerne un procédé de fabrication d'une mémoire ferroélectrique et en particulier un procédé de fabrication d'une mémoire ferroélectrique ayant une couche de matériau actif en dioxyde d'hafnium. La présente invention concerne également un procédé de co-fabrication d'une mémoire ferroélectrique et d'une mémoire résistive ayant une couche de matériau actif en dioxyde d'hafnium.

**ARRIERE-PLAN TECHNOLOGIQUE DE L'INVENTION**

Les mémoires ferroélectriques ou mémoires FeRAM ont pour principales qualités d'être non volatiles, c'est-à-dire de conserver l'information stockée même quand la tension est coupée, de consommer peu d'énergie et d'avoir des temps d'écriture et de lecture faibles par rapport à d'autres types de mémoires non volatiles comme les mémoires FLASH.

Les mémoires ferroélectriques sont des mémoires de type capacitif présentant deux états de polarisation rémanente +Pr et -Pr.

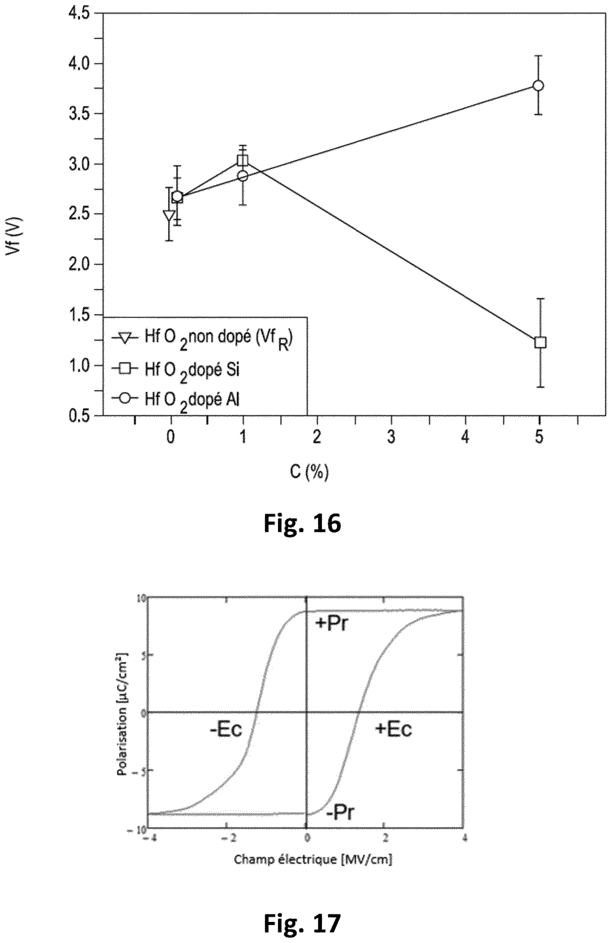

[Fig 17] illustre le fonctionnement des mémoires ferroélectriques.

Le fonctionnement des mémoires ferroélectriques est basé sur les propriétés ferroélectriques de leur matériau actif placé entre deux électrodes. Par l'application d'une différence de potentiels entre les deux électrodes créant un champ électrique d'une valeur supérieure au champ coercitif positif +Ec, la mémoire ferroélectrique est placée dans un état de polarisation rémanente haute +Pr et par l'application d'une différence de potentiels créant un champ électrique d'une valeur inférieure au champ coercitif négatif -Ec, la mémoire ferroélectrique est placée dans un état de polarisation rémanente basse -Pr. L'état de polarisation rémanente haute +Pr correspond alors à l'état logique binaire '0' et l'état de polarisation rémanente basse -Pr à l'état logique binaire '1', ce qui permet le stockage de l'information.

Les matériaux ferroélectriques classiquement utilisés dans les mémoires FeRAM, comme par exemple le titanate de plomb et de zirconium PZT et le tantalate de strontium et de bismuth SBT, ont l'inconvénient de ne pas être compatibles avec la technologie CMOS, leur préparation étant réalisée dans des salles blanches dédiées. De telles mémoires ferroélectriques ne peuvent donc pas être co-fabriquées avec d'autres types de mémoires ayant une couche active compatible avec le matériau actif ferroélectrique, ce qui limite leurs possibilités d'intégration.

Une alternative possible est alors d'utiliser du dioxyde d'hafnium $HfO_2$. L'inconvénient de ce matériau est qu'il ne présente des propriétés ferroélectriques que sous certaines conditions de dopage et de cristallisation contraignantes. En effet, le budget thermique nécessaire pour la cristallisation est très élevé puisque le dioxyde d'hafnium $HfO_2$ doit être soumis à des températures comprises entre 600°C et 1000°C pour cristalliser dans la phase appropriée. De telles températures sont en particulier incompatibles avec une intégration de type « back end » sur un transistor, c'est-à-dire une intégration successive aux étapes de fabrication du transistor. Ainsi, une mémoire ferroélectrique à base de dioxyde d'hafnium n'est pas compatible avec la technologie CMOS en intégration « back end ».

Il existe donc un besoin de fabriquer une mémoire ferroélectrique compatible avec la technologie CMOS en intégration « back end » et en intégration « front end » et dont les étapes de fabrication ne nécessitent pas de budget thermique important. Des procédés et des dispositifs de l'art antérieur sont connus par US 2081 / 0265967 A1, US 2018 / 0269057 A1, US 2016 / 0005749 A1, US 2018 / 0358471 A1, WO 2010 / 035980 A2 et CN 103165172 B.

**RESUME DE L'INVENTION**

L'invention offre une solution aux problèmes évoqués précédemment, en permettant de fabriquer une mémoire ferroélectrique pouvant être co-intégrée avec une mémoire résistive sans endommager par surchauffe les couches sous-jacentes au matériau actif de la mémoire ferroélectrique.

Un premier aspect de l'invention concerne un procédé de fabrication d'une mémoire ferroélectrique comportant une première électrode, une deuxième électrode et une couche de matériau actif en dioxyde d'hafnium $HfO_2$ disposée entre la première électrode et la deuxième électrode, le procédé comportant les étapes suivantes :

- une étape de dépôt d'une couche de première électrode ;
- une étape de dépôt de la couche de matériau actif ;
- une étape de dopage de la couche de matériau actif ;
- une étape de dépôt d'une couche de deuxième électrode ;
- une étape de recuit laser de la couche de matériau actif dopé pendant une durée ne dépassant pas 1 microseconde.

Grâce à l'invention, le recuit laser sub-microseconde permet de diminuer le temps de chauffage du matériau actif dopé ce qui permet la cristallisation adéquate du dioxyde d'hafnium dans la forme lui conférant des propriétés ferroélectriques sans surchauffer les couches sous-jacentes. Le recuit laser sub-microseconde permet également de concentrer le chauffage dans une zone précise. Le procédé est de plus, compatible avec la technologie CMOS en intégration « back end » et en intégration « front end ».

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Avantageusement, le dépôt de la première électrode et/ou le dépôt de la deuxième électrode sont de type PVD.

Avantageusement, la première électrode est en nitrure de titane TiN et la deuxième électrode est en nitrure de titane TiN ou en titane Ti.

Avantageusement, l'épaisseur de la première électrode est comprise entre 10 nm et 100 nm et l'épaisseur de la deuxième électrode comprise entre 10 nm et 100 nm.

Avantageusement, le dépôt de la couche de matériau actif est de type ALD.

Ainsi, il est possible de déposer une couche de matériau actif d'épaisseur faible.

Avantageusement, l'épaisseur de la couche de matériau actif est comprise entre 3 nm et 25 nm.

Avantageusement, l'étape de dopage est réalisée par implantation ionique ou à l'aide d'un précurseur de dopage.

Avantageusement, l'étape de recuit laser sub-microseconde comporte entre 1 et 1000 impulsions laser et préférentiellement entre 10 et 100 impulsions laser.

Avantageusement, la durée d'une impulsion laser est comprise entre 20 et 500 ns, plus préférentiellement entre 100 et 200 ns.

Avantageusement, la durée entre deux impulsions successives est d'au moins 100 $\mu$s.

Ainsi, le laser utilisé est un laser pulsé et non un laser continu, dont les impulsions sont d'une durée typiquement inférieure à 1 $\mu$s et espacées dans le temps d'au moins 100 $\mu$s, ce qui laisse le temps au matériau en surface de refroidir entre chaque impulsion. Il n'y a pas d'échauffement cumulatif significatif, ce qui permet de conserver les structures sous-jacentes à une température inférieure à 400°C malgré les pics de températures en surface au niveau du matériau actif de la mémoire ferroélectrique en cours de fabrication.

Avantageusement, la longueur d'onde du laser est comprise entre 150 et 550 nm, plus préférentiellement entre 150 et 360 nm.

Ainsi, le laser est préférentiellement un laser ultra-violet qui favorise une absorption en extrême surface et donc un dépôt de chaleur dans les tous premiers nanomètres seulement.

Avantageusement, l'étape de recuit laser sub-microseconde est réalisée après l'étape de dépôt de la deuxième électrode.

Avantageusement, un procédé de co-fabrication d'une mémoire ferroélectrique et d'une mémoire résistive comportant une première électrode, une deuxième électrode et une couche de matériau actif en dioxyde d'hafnium HfO2 disposée entre la première électrode et la deuxième électrode comporte les étapes du procédé de fabrication selon un premier aspect de l'invention et :

- une étape de dépôt d'une couche de première électrode de la mémoire résistive commune à l'étape de dépôt de la couche de première électrode de la mémoire ferroélectrique ;
- une étape de dépôt de la couche de matériau actif de la mémoire résistive commune à l'étape de dépôt de la couche de matériau actif de la mémoire ferroélectrique ;
- une étape de dépôt d'un masque sur la couche de matériau actif ;
- une étape de retrait d'au moins une partie du masque au niveau de la zone de la couche de matériau actif destinée à former la mémoire résistive en laissant le masque au niveau de la zone de la couche de matériau actif destinée à former la mémoire ferroélectrique ;
- l'étape de dopage de la couche de matériau actif réalisée par implantation ionique ;
- une étape de retrait du masque ;
- une étape de dépôt d'une couche de deuxième électrode commune à l'étape de dépôt de la couche de deuxième électrode de la mémoire ferroélectrique ;
- l'étape de recuit laser de la zone de la couche de matériau actif dopé destinée à former la mémoire ferroélectrique.

Ainsi, la mémoire ferroélectrique est co-intégrée avec une mémoire résistive.

Avantageusement, l'épaisseur du masque est telle que le masque ne laisse passer que 10% des éléments dopants lors de l'implantation ionique.

Ainsi, pour une même implantation ionique, la couche de matériau actif reçoit dix fois plus d'éléments dopants sans le masque qu'avec le masque.

Avantageusement, le masque est réalisé en nitrure de silicium SiN, en oxyde ou en résine.

Ainsi, le masque peut être facilement gravé.

Avantageusement, l'étape de retrait d'au moins une partie du masque de la mémoire résistive est réalisée avec arrêt sur la couche de matériau actif.

Ainsi, au niveau de la partie retirée, le dopage est dix fois plus important.

Avantageusement, la mémoire résistive est de type OxRAM ou CBRAM.

Ainsi, le matériau actif de la mémoire ferroélectrique est compatible avec le matériau actif de la mémoire résistive.

Avantageusement, l'élément dopant utilisé pour l'implantation ionique est du silicium Si, de l'aluminium Al, du germanium Ge ou du gadolinium Gd.

Ainsi, une fois cristallisé dans la forme adéquate, le dioxyde d'hafnium dopé avec l'un de ces éléments dopants a des propriétés ferroélectriques.

Un deuxième aspect de l'invention concerne un dispositif constitué d'un empilement comportant :

- une couche supérieure comportant au moins une mémoire ferroélectrique comportant une première électrode, une deuxième électrode et une couche de matériau actif en dioxyde d'hafnium $HfO_2$ disposée entre la première électrode et la deuxième électrode fabriquée par le procédé de fabrication ou par le procédé de co-fabrication selon un premier aspect de l'invention, et
- une couche inférieure comportant au moins un transistor MOS, caractérisé en ce qu'au moins un transistor MOS est verticalement recouvert par une mémoire ferroélectrique.

Avantageusement, le dispositif selon le deuxième aspect de l'invention comporte au moins une ligne d'interconnexion entre la couche inférieure et la couche supérieure

Avantageusement, la couche supérieure comporte au moins une mémoire résistive, la mémoire ferroélectrique et la mémoire résistive étant co-fabriquées par le procédé de co-fabrication selon le premier aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- Les figures 1 à 5 illustrent les différentes étapes du procédé de fabrication d'une mémoire ferroélectrique selon un premier aspect de l'invention.
- La figure 6 montre l'organigramme des étapes du procédé selon un premier aspect de l'invention illustrées aux figures 1 à 5.
- Les figures 7 à 14 illustrent les différentes étapes du procédé de co-fabrication d'une mémoire ferroélectrique et d'une mémoire résistive.
- La figure 15 montre l'organigramme des étapes du procédé de co-fabrication d'une mémoire ferroélectrique et d'une mémoire résistive illustrées aux figures 7 à 14.
- La figure 16 montre la variation de la tension de « forming » de la zone de commutation dans une couche de dioxyde d'hafnium de 10 nm d'épaisseur en fonction de la concentration atomique, exprimée en pourcentage, de silicium ou d'aluminium présent dans la couche de dioxyde d'hafnium.
- La figure 17 montre la variation de la polarisation d'un matériau ferroélectrique en fonction du champ électrique.
- La figure 18 est une représentation schématique du dispositif selon un deuxième aspect de l'invention.

## DESCRIPTION DETAILLEE D'AU MOINS UN MODE DE REALISATION DE L'INVENTION

Sauf précision contraire, un même élément apparaissant sur des figures différentes présente une référence unique.

Un premier aspect de l'invention concerne un procédé 100 de fabrication d'une mémoire ferroélectrique 401.

La mémoire ferroélectrique 401 ainsi fabriquée comporte :

- une première électrode 201 ;
- une couche de matériau actif 202 en dioxyde d'hafnium $HfO_2$ ; et
- une deuxième électrode 203.

Le dioxyde d'hafnium $HfO_2$ présente des propriétés ferroélectriques quand il est dopé avec un élément dopant particulier de manière à obtenir une concentration en élément dopant adéquate, puis cristallisé en phase orthorhombique.

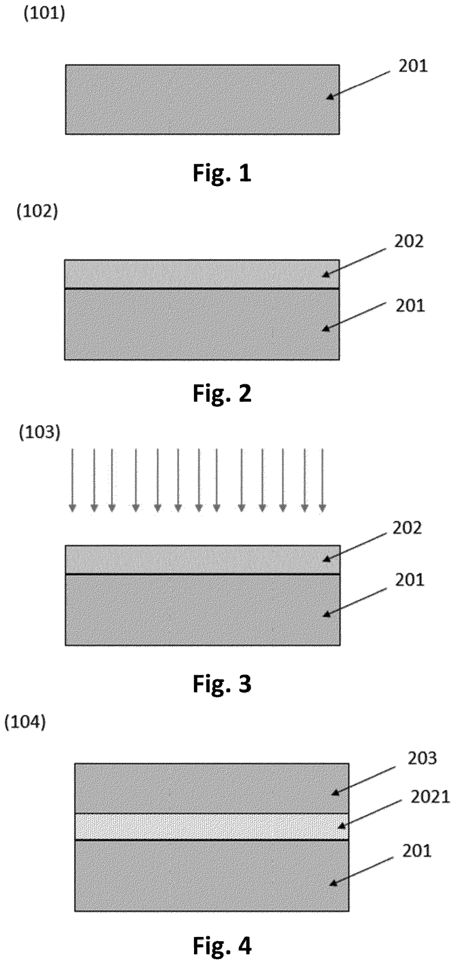

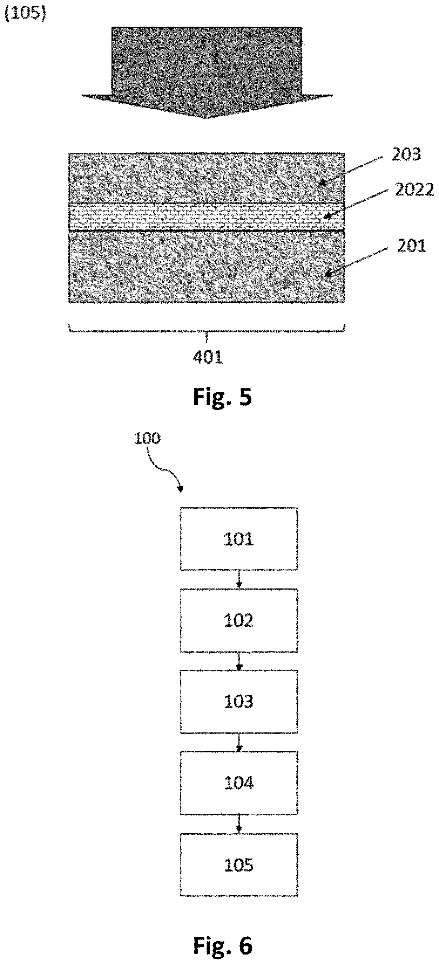

Les figures 1 à 5 illustrent les différentes étapes 101 à 105 (organigramme de la figure 6) du procédé 100 de fabrication d'une mémoire ferroélectrique 401.

[Fig 1] illustre la première étape 101 du procédé 100 selon un premier aspect de l'invention.

[Fig 2] illustre la deuxième étape 102 du procédé 100 selon un premier aspect de l'invention.

[Fig 3] illustre la troisième étape 103 du procédé 100 selon un premier aspect de l'invention.

[Fig 4] illustre la quatrième étape 104 du procédé 100 selon un premier aspect de l'invention.

[Fig 5] illustre la cinquième étape 105 du procédé 100 selon un premier aspect de l'invention.

[Fig 6] montre l'organigramme des étapes du procédé selon un premier aspect de l'invention illustrées aux figures 1 à 5.

L'étape 101 de dépôt d'une couche de première électrode 201 représentée à la figure 1 consiste à réaliser un dépôt conforme d'une couche de matériau conducteur de première électrode 201.

La première électrode 201 est par exemple disposée sur un substrat (non représenté), la première électrode 201 étant désignée comme électrode inférieure. La deuxième électrode 203 est alors désignée comme électrode supérieure.

Dans le contexte de l'invention, les termes « inférieure » et « supérieure » sont utilisés pour caractériser la position des électrodes dans le référentiel du substrat.

Le substrat est par exemple en silicium Si et d'autres couches peuvent déjà être formées dessus.

Le matériau conducteur de première électrode 201 est par exemple du nitrure de titane TiN.

Le dépôt est par exemple un dépôt physique en phase vapeur ou PVD pour « Physical Vapor Déposition ».

L'épaisseur de la première électrode 201 est par exemple comprise entre 10 nm et 200 nm.

L'étape 102 de dépôt de la couche de matériau actif 202 représentée à la figure 2 consiste à réaliser un dépôt conforme de dioxyde d'hafnium $HfO_2$.

Le dépôt de la couche de matériau actif 202 peut être réalisé directement sur la couche de première électrode 201 ou sur une autre couche préalablement déposée sur la couche de première électrode 201.

Le dépôt est par exemple un dépôt de couches minces atomiques ou ALD pour « Atomic Layer Déposition » qui permet de déposer des couches de faibles épaisseurs.

L'épaisseur de la couche de matériau actif 202 est par exemple comprise entre 5 et 25 nm. L'épaisseur de la couche de matériau actif 202 est par exemple d'environ 10 nm.

L'étape 103 est une étape de dopage de la couche de matériau actif 202. On entend par « dopage d'une couche », l'action d'introduire dans le matériau de la couche des atomes d'un autre matériau appelés impuretés.

Selon un mode de réalisation représenté sur la figure 3, l'étape 103 de dopage est réalisée par implantation ionique. Le dopage par implantation ionique consiste à accélérer des impuretés ionisées avec un champ électrique, afin de leur conférer l'énergie nécessaire pour rentrer dans le matériau à doper.

L'élément dopant utilisé est par exemple du silicium Si, de l'aluminium Al, du germanium Ge ou encore du gadolinium Gd.

Selon un mode de réalisation non représentée, l'étape 103 de dopage est réalisée à l'aide d'un précurseur de dopage. Par exemple, le précurseur de dopage est utilisé pendant le dépôt ALD en alternant les cycles de dépôt de dioxyde d'hafnium $HfO_2$ et d'éléments dopants et le nombre de cycles.

Le précurseur de dopage est par exemple du dioxyde de silicium $SiO_2$.

A l'issue de l'étape 103 de dopage, la couche de matériau actif 202 est devenue une couche de matériau actif dopé 2021.

L'étape 104 de dépôt d'une couche de deuxième électrode 203 représentée à la figure 4 consiste à réaliser un dépôt conforme d'une couche de matériau conducteur de deuxième électrode 203.

Le dépôt de la couche de deuxième électrode 203 peut être réalisé directement sur la couche de matériau actif dopé 2021 ou sur une autre couche préalablement déposée sur la couche de matériau actif dopé 2021.

Le matériau conducteur de deuxième électrode 203 est par exemple du nitrure de titane TiN ou du titane Ti.

Le dépôt est par exemple un dépôt physique en phase vapeur ou PVD pour « Physical Vapor Déposition ».

L'épaisseur de la deuxième électrode 203 est par exemple comprise entre 10 nm et 200 nm.

L'étape 105 de recuit laser sub-microseconde consiste à chauffer la couche de matériau actif dopé 2021 pendant une durée ne dépassant pas quelques microsecondes, selon l'invention 1 μs, pour obtenir une couche de matériau actif dopé et cristallisé au moins partiellement en phase orthorhombique 2022, permettant ainsi au dioxyde d'hafnium $HfO_2$ d'avoir des propriétés ferroélectriques, tout en ne détériorant pas par surchauffe les couches sous-jacentes. En effet, grâce à ce recuit laser de très courte durée, la chaleur déposée en surface de la mémoire ferroélectrique en cours de fabrication ne pénètre pas dans le volume de la mémoire ferroélectrique. La chaleur reste confinée dans les premiers 100 à 500 nm, voire 1 à 2 μm maximum.

L'étape 105 de recuit laser sub-microseconde peut comporter une unique impulsion laser ou une pluralité d'impulsions laser. Le nombre d'impulsions laser est par exemple compris entre 1 et 1000 ou entre 1 et 150 000 000 impulsions laser. Le nombre d'impulsions laser est par exemple compris entre 10 et 100, ou entre 1 et 1000 ou entre 1 et 100 impulsions laser.

La durée d'une impulsion laser doit être choisie pour chauffer uniquement la couche de matériau actif dopé 2021. En effet, la profondeur p de la zone chauffée par le laser dépend de la durée t de chauffage par la relation suivante :

[Math 1]

$$p = \sqrt{\alpha * t}$$

Avec :

[Math 2]

$$\alpha = \frac{k}{\rho * c_p}$$

Où k est la conductivité thermique du matériau chauffé, $\rho$ est la densité du matériau chauffé et $c_p$ est la capacité calorifique du matériau chauffé.

La durée d'une impulsion laser est par exemple comprise entre 20 et 500 ns et plus préférentiellement entre 100 et 200 ns, ce qui permet d'atteindre des profondeurs allant de 0.2 à 0.8 $\mu$m.

La durée entre deux impulsions successives est par exemple d'environ 100 $\mu$s.

Par exemple, la longueur d'onde du laser est comprise entre 150 et 550 nm, plus préférentiellement entre 150 et 360 nm. Par exemple, la longueur d'onde du laser est de 193 nm, 248 nm, 308 nm ou 355 nm.

La densité d'énergie déposée lors d'une impulsion laser est par exemple comprise entre 0.1 et 0.3 J/cm$^2$ ou comprise entre 0.1 et 0.45 J/cm$^2$ dans le cas d'un laser de longueur d'onde 308 nm et de durée d'impulsion d'environ 160 ns.

Selon un mode de réalisation représenté à la figure 6, l'étape 104 de dépôt de la couche de deuxième électrode 203 est réalisée avant l'étape 105 de recuit laser sub-m icroseconde.

Selon un autre mode de réalisation non représenté, l'étape 104 de dépôt de la couche de deuxième électrode est réalisée après l'étape 105 de recuit laser sub-microseconde. La couche de deuxième électrode 203 est alors déposée directement sur la couche de matériau actif dopé et cristallisé en phase orthorhombique 2022 ou sur une autre couche préalablement déposée sur la couche de matériau actif dopé et cristallisé en phase orthorhombique 2022.

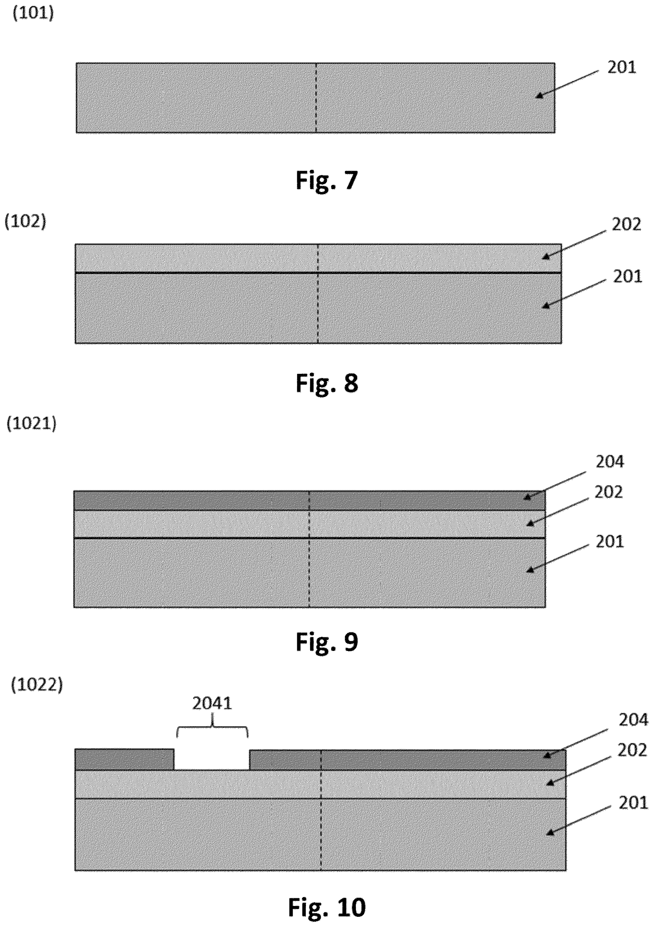

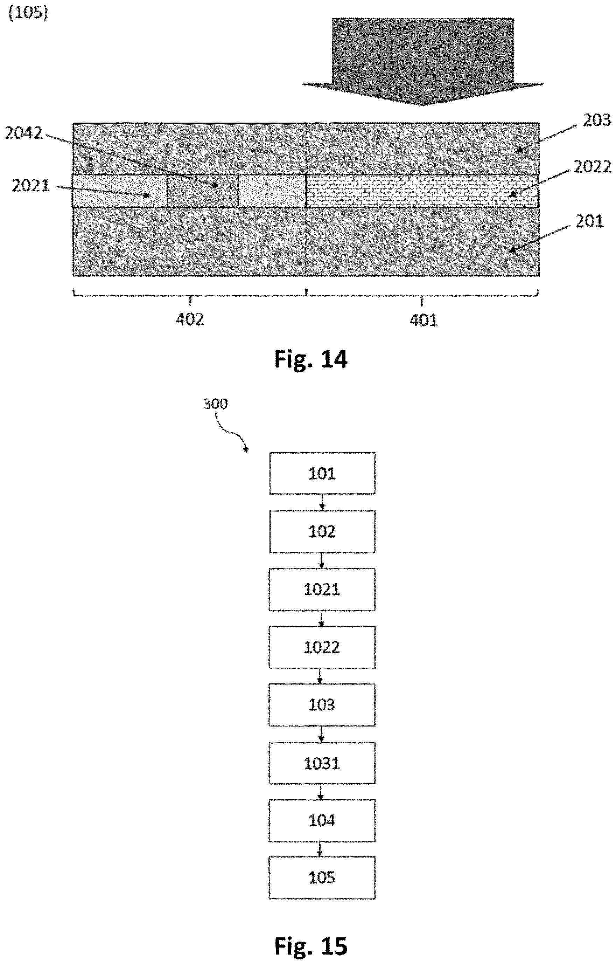

Les figures 7 à 14 illustrent les différentes étapes (organigramme de la figure 15) d'un procédé 300 de co-fabrication d'une mémoire ferroélectrique 401 et d'une mémoire résistive 402 comportant les étapes 101 à 105 du procédé 100 de fabrication d'une mémoire ferroélectrique 401.

[Fig 7] illustre la première étape 101 du procédé 300 de co-fabrication d'une mémoire ferroélectrique 401 et d'une mémoire résistive 402.

[Fig 8] illustre la deuxième étape 102 du procédé 300 de co-fabrication d'une mémoire ferroélectrique 401 et d'une mémoire résistive 402.

[Fig 9] illustre la troisième étape 1021 du procédé 300 de co-fabrication d'une mémoire ferroélectrique 401 et d'une mémoire résistive 402.

[Fig 10] illustre la quatrième étape 1022 du procédé 300 de co-fabrication d'une mémoire ferroélectrique 401 et d'une mémoire résistive 402.

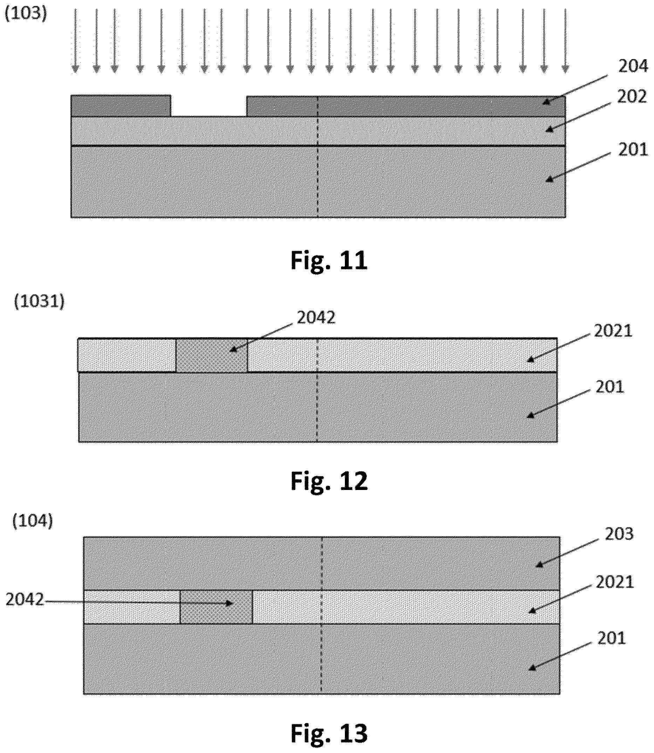

[Fig 11] illustre la cinquième étape 103 du procédé 300 de co-fabrication d'une mémoire ferroélectrique 401 et d'une mémoire résistive 402.

[Fig 12] illustre la sixième étape 131 du procédé 300 de co-fabrication d'une mémoire ferroélectrique 401 et d'une mémoire résistive 402.

[Fig 13] illustre la septième étape 104 du procédé 300 de co-fabrication d'une mémoire ferroélectrique 401 et d'une mémoire résistive 402.

[Fig 14] illustre la huitième étape 105 du procédé 300 de co-fabrication d'une mémoire ferroélectrique 401 et d'une mémoire résistive 402.

[Fig 15] montre l'organigramme des étapes du procédé 300 de co-fabrication d'une mémoire ferroélectrique 401 et d'une mémoire résistive 402 illustrées aux figures 7 à 14.

Le procédé 300 de co-fabrication permet la co-intégration d'une mémoire ferroélectrique 401 et d'une mémoire résistive 402 fonctionnant avec une couche de matériau actif en dioxyde d'hafnium HfO$_2$.

La mémoire résistive 402 ainsi fabriquée comporte :

- une première électrode 201 ;
- une couche de matériau actif 202 en dioxyde d'hafnium HfO$_2$ ; et
- une deuxième électrode 203.

La couche de matériau actif 202, et de manière plus générale la mémoire résistive 402, peut basculer de manière réversible entre deux états de résistance.

Au cours d'une opération d'écriture, une tension d'écriture est appliquée à la mémoire résistive 402 pour former une zone de commutation dans la couche de matériau actif 202, entre les première et deuxième électrodes 201 et 203. La mémoire résistive 402 passe ainsi dans un état à faible résistance, également appelé LRS pour « Low Resistance State » en anglais.

Au cours d'une opération d'effacement, une tension d'effacement est appliquée à la mémoire résistive 402 pour rompre la zone de commutation. La mémoire résistive 402 passe ainsi dans un état à forte résistance, également appelé HRS pour « High Résistance State » en anglais.

Lorsque la mémoire résistive 402 se trouve dans son état originel, juste après sa fabrication, la zone de commutation est formée pour la première fois en appliquant à la mémoire résistive 402 une tension de « forming » supérieure à la tension d'écriture. Ensuite, la mémoire résistive 402 entre dans un mode de fonctionnement normal dans lequel la tension d'écriture et la tension d'effacement sont utilisées pour faire basculer l'état de résistance de la mémoire résistive 402.

Quand la couche de matériau actif de la mémoire résistive 402 comporte une zone sur-dopée, la zone de commutation se forme pour la première fois dans cette zone sur-dopée et se reforme toujours à cet endroit au cours des opérations d'écriture ultérieures.

À tout moment, l'état de résistance dans lequel se trouve la mémoire résistive 402 peut être déterminé en lui appliquant une tension de lecture.

La mémoire résistive 402 est par exemple une mémoire de type OxRAM pour « Oxide Resistive RAM » ou une mémoire de type CBRAM pour « Conductive Bridge RAM ».

Dans les mémoires résistives de type OxRAM, la formation de la zone de commutation est due à l'accumulation de lacunes d'oxygène au sein de la couche de matériau actif 202.

Dans les mémoires résistives de type CBRAM, la formation de la zone de commutation est due à la formation d'un ou plusieurs filaments métalliques.

L'étape 101 de dépôt d'une couche de première électrode 201 de la mémoire résistive 402 représentée à la figure 7 est commune à l'étape 101 de dépôt d'une couche de première électrode 201 de la mémoire ferroélectrique 401 représentée à la figure 1, c'est-à-dire qu'une unique couche de première électrode 201 est déposée et qu'une première zone de cette unique couche de première électrode 201 est destinée à être la couche de première électrode 201 de la mémoire résistive 402 et qu'une deuxième zone de la couche de première électrode 201 est destinée à être la couche de première électrode 201 de la mémoire ferroélectrique 402.

De même, l'étape 102 de dépôt de la couche de matériau actif 202 de la mémoire résistive 402 représentée à la figure 8 est commune à l'étape 102 de dépôt de la couche de matériau actif 202 de la mémoire ferroélectrique 401 représentée à la figure 2, c'est-à-dire qu'une unique couche de matériau actif 202 est déposée et qu'une première zone de cette unique couche de matériau actif 202 est destinée à être la couche de matériau actif 202 de la mémoire résistive 402 et qu'une deuxième zone de la couche de matériau actif 202 est destinée à être la couche de matériau actif 202 de la mémoire ferroélectrique 401. La première zone de la couche de matériau actif 202 est appelée par la suite zone de la couche de matériau actif 202 de la mémoire résistive 402 et la deuxième zone de la couche de matériau actif 202 est appelée par la suite zone de la couche de matériau actif 202 de la mémoire ferroélectrique 401.

Une étape 1021 de dépôt d'un masque 204 représentée à la figure 9 consiste à réaliser un dépôt conforme de masque 204 sur la couche de matériau actif 202, c'est-à-dire sur la zone de la couche de matériau actif 202 de la mémoire résistive 402 et sur la zone de la couche de matériau actif 202 de la mémoire ferroélectrique 401. La partie du masque déposée sur la zone de la couche de matériau actif 202 de la mémoire résistive 402 est appelé par la suite masque de la mémoire résistive 402 et la partie du masque déposée sur la zone de la couche de matériau actif 202 de la mémoire ferroélectrique 401 est appelé par la suite masque de la mémoire ferroélectrique 401.

Le masque 204 est par exemple réalisé en nitrure de silicium SiN, en nitrure de titane TiN, en oxyde ou en résine.

Selon un mode de réalisation représenté à la figure 10, une étape 1022 de retrait d'au moins une partie 2041 du masque 204 de la mémoire résistive 402 est réalisée avec arrêt sur la couche de matériau actif 202. Ainsi, à l'issue de l'étape 1022 de retrait, au moins une partie de la zone de la couche de matériau actif 202 de la mémoire résistive 402 est mise à nu, c'est-à-dire directement accessible en surface.

Selon un autre mode de réalisation non représenté, l'étape 1022 de retrait d'au moins une partie 2041 du masque 204 de la mémoire résistive 402 est réalisée sans mettre à nu la couche de matériau actif 202, c'est-à-dire en laissant une épaisseur plus mince de masque 204.

Lors de cette étape 1022 de retrait d'au moins une partie 2041 du masque 204 de la mémoire résistive 402, le masque 204 de la mémoire ferroélectrique 401 est laissé intact.

L'étape 1022 de retrait d'au moins une partie 2041 du masque 204 de la mémoire résistive 402 est par exemple réalisée par lithographie et gravure.

L'étape 103, représentée à la figure 11, est une étape de dopage de la couche de matériau actif 202 par implantation ionique, c'est-à-dire de dopage de la zone de la couche de matériau actif 202 de la mémoire résistive 402 et de la zone de la couche de matériau actif 202 de la mémoire ferroélectrique 401.

Par exemple, l'épaisseur du masque 204 est choisie pour que les parties de la couche de matériau actif 202 recouverte du masque 204 reçoive dix fois moins d'ions que les parties de la couche de matériau actif 202 mises à nu lors de l'étape 1022 de retrait d'au moins une partie 2041 du masque 204 de la mémoire résistive 402. L'épaisseur du masque 204 dépend alors du matériau constituant le masque 204. Par exemple, pour du nitrate de silicium SiN, l'épaisseur est d'environ 11 nm. Par exemple, pour du dioxyde de silicium $SiO_2$, l'épaisseur est d'environ 14 nm. Par exemple, pour du nitrate de titane TiN, l'épaisseur est d'environ 8 nm.

A l'issue de l'étape 103, la couche de matériau actif 202 est devenue une couche de matériau actif dopé 2021 comportant des zones 2042 sur-dopées correspondant aux parties de la zone de la couche de matériau actif 202 de la mémoire résistive 402 mises à nu lors de l'étape 1022 de retrait d'au moins une partie 2041 du masque 204 de la mémoire résistive 402.

En continuant avec l'exemple précédent, les zones 2042 sur-dopées de la zone de la couche de matériau actif 202 de la mémoire résistive 402 présentent dix fois plus de dopage que le reste de la couche de matériau actif dopé 2021. Par exemple, les zones 2042 sur-dopées sont exposées à une dose comprise entre $10^{15}$ ions/$cm^2$ et $5.10^{15}$ ions/$cm^2$ et le reste de la couche de matériau actif dopé 2021 est exposé à une dose comprise entre $10^{14}$ ions/$cm^2$ et $5.10^{14}$ ions/$cm^2$.

Lorsque la couche de matériau actif 202 de la mémoire résistive 402 est dopée avec un élément dopant adéquat, comme par exemple de l'aluminium Al ou du silicium Si, la tension de « forming » de la zone de commutation dans la couche de matériau actif 202 varie en fonction de la concentration atomique en élément dopant dans la couche de matériau actif 202.

La concentration atomique C de l'élément dopant dans une zone considérée de la couche de matériau actif 202 est exprimée en pourcentage et est définie par la relation suivante :

[Math 3]

$$C = 100 * \frac{C_{dopant}}{C_{ma} + C_{dopant}}$$

où $C_{dopant}$ est la concentration d'atomes de l'élément dopant présents dans la zone considérée, et $C_{ma}$ est la concentration d'atomes constituant la couche de matériau actif 202 non dopée, ces concentrations $C_{dopant}$ et $C_{ma}$ étant exprimées en nombre d'atomes par $cm^{-3}$.

La tension de « forming » lorsque la concentration atomique C de l'élément dopant est nulle, c'est-à-dire lorsque la couche de matériau actif 202 n'est pas dopée, est prise comme tension de référence.

Par exemple, lorsque la couche de matériau actif 202 est dopée avec du silicium Si, la tension de « forming » commence par augmenter avec la concentration atomique C en silicium Si jusqu'à atteindre une valeur maximale. Ensuite, lorsque la concentration atomique C en silicium Si continue d'augmenter, la tension de « forming » diminue, en passant sous la tension de référence.

Par exemple, lorsque la couche de matériau actif 202 est dopée avec de l'aluminium Al, la tension de « forming » augmente linéairement avec la concentration atomique C en aluminium Al.

Ces phénomènes sont illustrés sur les courbes de la figure 16.

[Fig 16] représentent la variation de la tension de « forming » Vf mesurée dans le dioxyde d'hafnium $HfO_2$ en fonction de la concentration atomique C de l'élément dopant présent dans le dioxyde d'hafnium $HfO_2$.

Dans le cas du silicium Si, la tension de « forming » Vf est supérieure à la tension de référence $V_{fR}$ lorsque la concentration atomique C en silicium Si est comprise entre 0,1% et 2%, et la valeur maximale de la tension de « forming » Vf semble être atteinte pour une concentration atomique C en silicium Si de l'ordre de 1%.

Au contraire, la tension de « forming » Vf est inférieure à la tension de référence $V_{fR}$ lorsque la concentration atomique C en silicium Si est supérieure à 2%.

Par contre, dans le cas de l'aluminium, la tension de « forming » Vf est toujours supérieure à la tension de référence $V_{fR}$ quelle que soit la concentration atomique C en aluminium Al.

A l'issue de l'étape 103, la zone de la couche de matériau actif 202 de la mémoire résistive 402 comporte au moins une zone 2042 sur-dopée dans laquelle la concentration atomique C en élément dopant est choisie de manière à localiser la zone de commutation dans une zone 2042 sur-dopée.

En d'autres termes, cela revient à faire en sorte qu'une zone 2042 sur-dopée présente une tension de « forming » inférieure à la tension de « forming » dans le reste de la couche de matériau actif 202 moins dopée.

Ainsi, en appliquant à la mémoire résistive 402 une tension de « forming » comprise entre la tension de « forming » dans le reste de la couche de matériau actif 202 et la tension de « forming » de la zone 2042 sur-dopée, il est possible de former la zone de commutation dans une zone 2042 sur-dopée.

Le procédé 300 de co-fabrication permet donc de contrôler la localisation de la zone de commutation de la mémoire résistive 402 en fonction du dopage de la couche de matériau actif 202, ce qui permet de réduire la variabilité entre les mémoires résistives 402.

L'étape 1031, représentée à la figure 12, est une étape de retrait du masque 204, c'est-à-dire du masque de la mémoire ferroélectrique 401 et des parties restantes de masque de la mémoire résistive 4012.

L'étape 1031 est par exemple réalisée par un procédé de gravure sèche (plasma oxygène dans le cas d'un masque résine, plasma fluoro carboné dans le cas d'un masque en oxyde de silicium ou nitrure de silicium), ou un procédé de gravure humide (acide orthophosphorique dilué dans le cas d'un masque en nitrure de silicium, ou acide fluorhydrique dilué dans le cas d'un masque en oxyde de silicium ou nitrure de silicium), ces procédés étant sélectifs par rapport au matériau actif.

L'étape 104 de dépôt de la couche de deuxième électrode 203 de la mémoire résistive 402 représentée à la figure 12 est commune à l'étape 104 de dépôt de la couche de deuxième électrode 203 de la mémoire ferroélectrique 401 représentée à la figure 4, c'est-à-dire qu'une unique couche de deuxième électrode 203 est déposée et qu'une première zone de cette unique couche de deuxième électrode 203 est destinée à former la couche de deuxième électrode 203 de la mémoire résistive 402 et qu'une deuxième zone de la couche de deuxième électrode 203 est destinée à former la couche de deuxième électrode 203 de la mémoire ferroélectrique 401.

L'étape 105 de recuit laser sub-microseconde consiste à chauffer uniquement la zone de la couche de matériau actif dopé 2021 de la mémoire ferroélectrique 501 pour obtenir une couche de matériau actif dopé et cristallisé en phase orthorhombique 2022 uniquement au niveau de la zone de la couche de matériau actif destinée à former la mémoire ferroélectrique 501.

A l'issue de l'étape 105 de recuit laser sub-microseconde du procédé 300 de co-fabrication, la zone de la couche de matériau actif 2022 de la mémoire ferroélectrique 501 est dopée et cristallisée en phase orthorhombique et la zone de la couche de matériau actif 2021 de la mémoire résistive 502 est dopée et présente au moins une zone 2042 sur-dopée dans laquelle va se former la zone de commutation.

Selon un mode de réalisation représenté à la figure 15, l'étape 104 de dépôt de la couche de deuxième électrode 203 est réalisée avant l'étape 105 de recuit laser sub-m icroseconde.

Selon un autre mode de réalisation non représenté, l'étape 104 de dépôt de la couche de deuxième électrode 203 est réalisée après l'étape 105 de recuit laser sub-m icroseconde.

Un deuxième aspect de l'invention concerne un dispositif constitué d'un empilement comportant une couche supérieure et une couche inférieure.

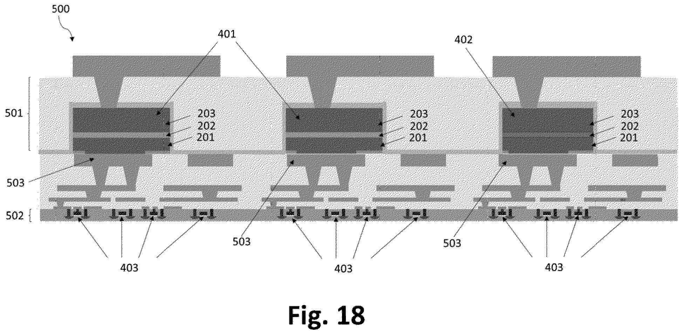

[Fig 18] montre une représentation schématique du dispositif 500 selon un deuxième aspect de l'invention.

La couche supérieure 501 comporte au moins une mémoire ferroélectrique 401 fabriquée par le procédé 100, 300, c'est-à-dire une mémoire ferroélectrique 401 comportant une première électrode 201, une deuxième électrode 203 et une couche de matériau actif 202 en dioxyde d'hafnium $HfO_2$ disposée entre la première électrode 201 et la deuxième électrode 203.

Comme illustré sur la figure 18, la couche supérieure 501 peut également comporter une mémoire résistive 402. Dans ce cas, la mémoire ferroélectrique 401 et la mémoire résistive 502 sont co-fabriquées selon le procédé 300.

La couche inférieure 502 comporte au moins un transistor MOS 403. Selon un exemple de réalisation, le transistor MOS est un transistor CMOS, compatible avec la technologie CMOS.

La couche supérieure 501 et la couche inférieure 502 sont disposées de manière qu'au moins un transistor MOS 403 soit verticalement recouvert par une mémoire ferroélectrique 401.

On entend par « un premier élément est verticalement recouvert par un deuxième élément », que le deuxième élément est situé au-dessus du premier élément selon un axe vertical perpendiculaire au premier élément et passant par le premier élément. Selon cette définition, le premier élément peut ne pas être en contact physique avec le deuxième élément.

La couche inférieure 502, et en particulier un transistor MOS 403, est par exemple en contact électrique avec la couche supérieure 501, et en particulier avec une mémoire ferroélectrique 401, via au moins une ligne d'interconnexion métallique 503, également appelée via métallique.

Une électrode d'un transistor MOS 403, par exemple le drain, peut être en contact physique avec la première électrode 201 d'une mémoire ferroélectrique 401.

Le transistor MOS ou l'ensemble des transistors MOS de la couche inférieure 502 sont fabriqués en front-end of the line, avec des budgets thermiques élevés pouvant aller jusqu'à 1100°C, alors que la couche supérieure 501 comportant la mémoire ferroélectrique 401 est intégré en back-end of the line, avec un budget thermique (hors recuit laser), limité à 400°C. L'utilisation du laser sub-microseconde évite tout impact négatif sur les propriétés électriques des transistors MOS et sur les niveaux d'interconnexions métalliques 503 lorsqu'il y en a. De plus, l'utilisation du laser sub-microseconde permet d'améliorer les propriétés de la couche ferroélectrique 202 en autorisant une cristallisation dans une phase compatible avec un comportement ferroélectrique.

Le dispositif 500 présente une structure appelée 1T/1R, couramment utilisée pour réduire les courants de fuite au sein d'une architecture de type « cross-bar » intégrant des mémoires résistives avec de fortes densités.

## Revendications

1. Procédé (100) de fabrication d'une mémoire ferroélectrique (401) comportant une première électrode (201), une deuxième électrode (203) et une couche de matériau actif (202) en dioxyde d'hafnium $HfO_2$ disposée entre la première électrode (201) et la deuxième électrode (203), le procédé comportant les étapes suivantes :

   - une étape (101) de dépôt d'une couche de première électrode (201) ;
   - une étape (102) de dépôt de la couche de matériau actif (202) ;
   - une étape (103) de dopage de la couche de matériau actif (202) ;
   - une étape (104) de dépôt d'une couche de deuxième électrode (203) ; le procédé étant **caractérisé en ce qu'**il comporte une étape (105) de recuit laser de la couche de matériau actif dopé (2021) pendant une durée ne dépassant pas 1 microseconde.

2. Procédé (100) selon la revendication 1, **caractérisé en ce que** l'étape (105) de recuit laser comporte entre 1 et 1000 impulsions laser et préférentiellement entre 10 et 100 impulsions.

3. Procédé (100) selon la revendication 2, **caractérisé en ce que** la durée d'une impulsion laser est comprise entre 20 et 500 ns et plus préférentiellement entre 100 et 200 ns.

4. Procédé (100) selon l'une quelconque des revendications précédentes, **caractérisé en ce que** la longueur d'onde du laser est comprise entre 150 et 550 nm, plus préférentiellement entre 150 et 360 nm.

5. Procédé (100) selon l'une quelconque des revendications précédentes, **caractérisé en ce que** l'étape de dopage est réalisée par implantation ionique ou à l'aide d'un précurseur de dopage.

6. Procédé (300) de co-fabrication d'une mémoire ferroélectrique (401) et d'une mémoire résistive (402) comportant une première électrode (201), une deuxième électrode (203) et une couche de matériau actif (202) en dioxyde d'hafnium $HfO_2$ disposée entre la première électrode (201) et la deuxième électrode (203), le procédé (300) de co-fabrication comportant les étapes du procédé (100) de fabrication selon l'une quelconque des revendications précédentes, **caractérisé en ce que** le procédé (300) de co-fabrication comporte:

   - une étape (101) de dépôt d'une couche de première électrode (201) de la mémoire résistive (402) commune à l'étape (101) de dépôt de la couche de première électrode (201) de la mémoire ferroélectrique (401) ;
   - une étape (102) de dépôt de la couche de matériau actif (202) de la mémoire résistive (402) commune à l'étape (102) de dépôt de la couche de matériau actif (202) de la mémoire ferroélectrique (401) ;
   - une étape (1021) de dépôt d'un masque (204) sur la couche de matériau actif (202) ;
   - une étape (1022) de retrait d'au moins une partie (2041) du masque (204) au niveau de la zone de la couche de matériau actif (202) destinée à former la mémoire résistive (402) en laissant le masque au niveau de la zone de la couche de matériau actif (202) destinée à former la mémoire ferroélectrique (401) ;
   - l'étape (103) de dopage de la couche de matériau actif (202) réalisée par implantation ionique ;
   - une étape (1031) de retrait du masque (204) ;
   - une étape (104) de dépôt d'une couche de deuxième électrode (203) commune à l'étape (104) de dépôt de la couche de deuxième électrode (201) de la mémoire ferroélectrique (401) ;
   - l'étape (105) de recuit laser de la zone de la couche de matériau actif dopé (2021) destinée à former la mémoire ferroélectrique (401).

7. Procédé (300) selon la revendication 6, **caractérisé en ce que** l'épaisseur du masque (204) est telle que le masque (204) ne laisse passer que 10% des éléments dopants lors de l'implantation ionique.

8. Procédé (300) selon l'une quelconque des revendications 6 à 7, **caractérisé en ce que** l'étape (1022) de retrait d'au moins une partie (2041) du masque de la mémoire résistive (402) est réalisée avec arrêt sur la couche de matériau actif (202).

9. Procédé (300) selon l'une quelconque des revendications 6 à 8, **caractérisé en ce que** la mémoire résistive (402) est de type OxRAM ou CBRAM.

10. Procédé (100, 300) selon l'une quelconque des revendications précédentes, **caractérisé en ce que** l'élément dopant utilisé pour l'implantation ionique est du silicium Si, de l'aluminium Al, du germanium Ge ou du gadolinium Gd.

11. Dispositif (500) constitué d'un empilement comportant :

   - une couche supérieure (501) comportant au moins une mémoire ferroélectrique (401) comportant une première électrode (201), une deuxième électrode (203) et une couche de matériau actif (202) en dioxyde d'hafnium $HfO_2$ disposée entre la première électrode (201) et la deuxième électrode (203) fabriquée par le procédé de fabrication (100) selon l'une quelconque des revendications 1 à 5 ou par le procédé de co-fabrication (300) selon l'une quelconque des revendications 6 à 10, et
   - une couche inférieure (502) comportant au moins un transistor MOS (403),

   **caractérisé en ce qu'**au moins un transistor MOS (403) est verticalement recouvert par une mémoire ferroélectrique (401).

12. Dispositif (500) selon la revendication 11, **caractérisé en ce qu'**il comporte au moins une ligne d'interconnexion (503) entre la couche inférieure (502) et la couche supérieure (501).

13. Dispositif (500) selon l'une quelconque des revendications 11 ou 12, **caractérisé en ce que** la couche supérieure (501) comporte au moins une mémoire résistive (402), la mémoire ferroélectrique (401) et la mémoire résistive (402) étant co-fabriquées par le procédé de co-fabrication (300) selon l'une quelconque des revendications 6 à 10.

**Patentansprüche**

1. Verfahren (100) zur Herstellung eines ferroelektrischen Speichers (401) mit einer ersten Elektrode (201), einer zweiten Elektrode (203) und einer Schicht aus aktivem Material (202) aus Hafniumdioxid Hf02, die zwischen der ersten Elektrode (201) und der zweiten Elektrode (203) angeordnet ist, wobei das Verfahren die folgenden Schritte umfasst:

   - einen Schritt (101) des Aufbringens einer Schicht der ersten Elektrode (201;
   - einen Schritt (102) des Aufbringens der Schicht aus aktivem Material (202);
   - einen Schritt (103) des Dotierens der Schicht aus aktivem Material (202);
   - einen Schritt (104) des Aufbringens einer Schicht der zweiten Elektrode (203); wobei das Verfahren **dadurch gekennzeichnet ist, dass** es einen Schritt (105) des Laserglühens der Schicht aus dotiertem aktiven Material (2021) für eine Dauer von nicht mehr als 1 Mikrosekunde umfasst.

2. Verfahren (100) nach Anspruch 1, **dadurch gekennzeichnet, dass** der Schritt (105) des Laserglühens zwischen 1 und 1000 Laserimpulse und vorzugsweise zwischen 10 und 100 Impulse umfasst.

3. Verfahren (100) nach Anspruch 2, **dadurch gekennzeichnet, dass** die Dauer eines Laserpulses zwischen 20 und 500 ns und besonders bevorzugt zwischen 100 und 200 ns liegt.

4. Verfahren (100) nach einem der vorhergehenden Ansprüche, **dadurch gekennzeichnet, dass** die Wellenlänge des Lasers zwischen 150 und 550 nm, besonders bevorzugt zwischen 150 und 360 nm liegt.

5. Verfahren (100) nach einem der vorhergehenden Ansprüche, **dadurch gekennzeichnet, dass** der Dotierungsschritt durch Ionenimplantation oder mithilfe eines Dotierungsvorläufers durchgeführt wird.

6.  Verfahren (300) zur gemeinsamen Herstellung eines ferroelektrischen Speichers (401) und eines resistiven Speichers (402) mit einer ersten Elektrode (201), einer zweiten Elektrode (203) und einer zwischen der ersten Elektrode (201) und der zweiten Elektrode (203) angeordneten Schicht aus aktivem Material (202) aus Hafniumdioxid Hf02, wobei das Verfahren (300) zur gemeinsamen Herstellung die Schritte des Verfahrens (100) zur Herstellung nach einem der vorhergehenden Ansprüche umfasst, **dadurch gekennzeichnet, dass** das Verfahren (300) zur gemeinsamen Herstellung Folgendes umfasst:

    - einen Schritt (101) des Aufbringens einer ersten Elektrodenschicht (201) des resistiven Speichers (402), der zusammen mit dem Schritt (101) des Aufbringens der ersten Elektrodenschicht (201) des ferroelektrischen Speichers (401) erfolgt;
    - einen Schritt (102) des Aufbringens der Schicht aus aktivem Material (202) des resistiven Speichers (402), der zusammen mit dem Schritt (102) des Aufbringens der Schicht aus aktivem Material (202) des ferroelektrischen Speichers (401) erfolgt;
    - einen Schritt (1021) des Aufbringens einer Maske (204) auf die Schicht aus aktivem Material (202);
    - einen Schritt des Entfernens zumindest eines Teils (2041) der Maske (204) im Bereich der ersten Schicht aus aktivem Material (202), der dazu bestimmt ist, den resistiven Speicher (402) zu bilden, wobei die Maske im Bereich der ersten Schicht aus aktivem Material (202), der dazu bestimmt ist, den ferroelektrischen Speicher (401) zu bilden, zurückbleibt.
    - den Schritt (103) des Dotierens der Schicht aus aktivem Material (202), der durch Ionenimplantation durchgeführt wird;
    - einen Schritt (1031) des Entfernens der Maske (204);
    - einen Schritt (104) des Aufbringens einer zweiten Elektrodenschicht (203), der zusammen mit dem Schritt (104) des Aufbringens der zweiten Elektrodenschicht (201) des ferroelektrischen Speichers (401) erfolgt;
    - den Schritt (105) des Laserglühens des Bereichs der Schicht aus dotiertem aktiven Material (2021), der den ferroelektrischen Speicher (401) bilden soll.

7.  Verfahren (300) nach Anspruch 6, **dadurch gekennzeichnet, dass** die Dicke der Maske (204) so ist, dass die Maske (204) bei der Ionenimplantation nur 10% der Dotierungselemente durchlässt.

8.  Verfahren (300) nach einem der Ansprüche 6 bis 7, **dadurch gekennzeichnet, dass** der Schritt (1022) des Entfernens mindestens eines Teils (2041) der Maske des resistiven Speichers (402) mit Anhalten auf der Schicht aus aktivem Material (202) durchgeführt wird.

9.  Verfahren (300) nach einem der Ansprüche 6 bis 8, **dadurch gekennzeichnet, dass** der resistive Speicher (402) vom OxRAM- oder CBRAM-Typ ist.

10. Verfahren (100, 300) nach einem der vorhergehenden Ansprüche, **dadurch gekennzeichnet, dass** das für die Ionenimplantation verwendete Dotierungselement Silizium Si, Aluminium Al, Germanium Ge oder Gadolinium Gd ist.

11. Vorrichtung (500), die aus einer Schichtung besteht, die Folgendes umfasst:

    - eine obere Schicht (501) mit mindestens einem ferroelektrischen Speicher (401) mit einer ersten Elektrode (201), einer zweiten Elektrode (203) und einer zwischen der ersten Elektrode (201) und der zweiten Elektrode (203) angeordneten Schicht aus aktivem Material (202) aus Hafniumdioxid Hf02, die durch das Herstellungsverfahren (100) nach einem der Ansprüche 1 bis 5 oder durch das gemeinsame Herstellungsverfahren (300) nach einem der Ansprüche 6 bis 10 hergestellt wird, und
    - eine untere Schicht (502) mit mindestens einem MOS-Transistor (403),
    - **dadurch gekennzeichnet, dass** mindestens ein MOS-Transistor (403) vertikal von einem ferroelektrischen Speicher (401) bedeckt ist.

12. Vorrichtung (500) nach Anspruch 11, **dadurch gekennzeichnet, dass** sie mindestens eine Verbindungsleitung (503) zwischen der unteren Schicht (502) und der oberen Schicht (501) aufweist.

13. Vorrichtung (500) nach einem der Ansprüche 11 oder 12, **dadurch gekennzeichnet, dass** die obere Schicht (501) mindestens einen resistiven Speicher (402) aufweist, wobei der ferroelektrische Speicher (401) und der resistive Speicher (402) durch das gemeinsame Fertigungsverfahren (300) nach einem der Ansprüche 6 bis 10 gemeinsam hergestellt werden.

**Claims**

1. Method (100) of fabrication of a ferroelectric memory (401) comprising a first electrode (201), a second electrode (203) and a layer of active material (202) made of hafnium dioxide $HfO_2$ positioned between the first electrode (201) and the second electrode (203), where the method comprises the following steps:

   - a step (101) of deposition of a first electrode layer (201);
   - a step (102) of deposition of the layer of active material (202);
   - a step (103) of doping of the layer of active material (202);
   - a step (104) of deposition of a second electrode layer (203); where the method is **characterised by** the fact that it comprises a step (105) of laser annealing of the layer of doped active material (2021) for a duration which does not exceed 1 $\mu$s.

2. Method (100) according to claim 1, **characterised by** the fact that the step (105) of laser annealing comprises between 1 and 1000 laser pulses and preferentially between 10 and 100 pulses.

3. Method (100) according to claim 2, **characterised by** the fact that the duration of a laser pulse is between 20 and 500 ns, and more preferentially between 100 and 200 ns.

4. Method (100) according to any of the previous claims, **characterised by** the fact that the wavelength of the laser is between 150 and 550 nm, and more preferentially between 150 and 360 nm.

5. Method (100) according to any of the previous claims, **characterised by** the fact that the doping step is accomplished by ionic implantation or using a doping precursor.

6. Method (300) of co-fabrication of a ferroelectric memory (401) and of a resistive memory (402) comprising a first electrode (201), a second electrode (203) and a layer of active material (202) made of hafnium dioxide $HfO_2$ positioned between the first electrode (201) and the second electrode (203), where the method (300) of co-fabrication comprises the steps of method (100) of fabrication according to any of the previous claims, **characterised by** the fact that the method (300) of co-fabrication comprises:

   - a step (101) of deposition of a first electrode layer (201) of the resistive memory (402) common to the step (101) of deposition of the first electrode layer (201) of the ferroelectric memory (401);
   - a step (102) of deposition of the layer of active material (202) of the resistive memory (402) common to the step (102) of deposition of the layer of active material (202) of the ferroelectric memory (401);
   - a step (1021) of deposition of a mask (204) on the layer of active material (202);
   - a step (1022) of removal of at least a portion (2041) of the mask (204) in the zone of the layer of active material (202) intended to form the resistive memory (402), leaving the mask in the zone of the layer of active material (202) intended to form the ferroelectric memory (401);
   - the step (103) of doping of the layer of active material (202) accomplished by ionic implantation;
   - a step (1031) of removal of the mask (204);
   - a step (104) of deposition of a second electrode layer (201) common to the step (104) of deposition of the second electrode layer (201) of the ferroelectric memory (401);
   - the step (105) of laser annealing of the zone of the layer of doped active material (2021) intended to form the ferroelectric memory (401).

7. Method (300) according to claim 6, **characterised by** the fact that the thickness of the mask (204) is such that the mask (204) allows only 10% of the doping elements to pass through during ionic implantation.

8. Method (300) according to either of claims 6 or 7, **characterised by** the fact that the step (1022) of removal of at least a portion (2041) of the mask of the resistive memory (402) is accomplished stopping at the layer of active material (202).

9. Method (300) according to any of claims 6 to 8, **characterised by** the fact that the resistive memory (402) is of the OxRAM or CBRAM type.

10. Method (100, 300) according to any of the previous claims, **characterised by** the fact that the doping element used for ionic implantation is silicon Si, aluminium Al, germanium Ge or gadolinium Gd.

**11.** Device (500) constituting of a stack comprising:

- an upper layer (501) comprising at least one ferroelectric memory (401) comprising a first electrode (201), a second electrode (203) and a layer of active material (202) made of hafnium dioxide $HfO_2$ positioned between the first electrode (201) and the second electrode (203) fabricated by the method of fabrication (100) according to any of claims 1 to 5 or by the method of co-fabrication (300) according to any of claims 6 to 10, and
- a lower layer (502) comprising at least one MOS transistor (403),

**characterised by** the fact that at least one MOS transistor (403) is vertically covered by one ferroelectric memory (401).

**12.** Device (500) according to claim 11, **characterised by** the fact that it comprises at least one interconnection line (503) between the lower layer (502) and the upper layer (501).

**13.** Device (500) according to either of claims 11 or 12, **characterised by** the fact that the upper layer (501) comprises at least one resistive memory (402), where the ferroelectric memory (401) and the resistive memory (402) are co-fabricated by the method of co-fabrication (300) according to any of claims 6 to 10.

(101)

201

**Fig. 1**

(102)

202

201

**Fig. 2**

(103)

202

201

**Fig. 3**

(104)

203

2021

201

**Fig. 4**

(105)

203

2022

201

401

**Fig. 5**

100

| 101 |
|-----|

| 102 |
|-----|

| 103 |
|-----|

| 104 |
|-----|

| 105 |
|-----|

**Fig. 6**

(101)

201

**Fig. 7**

(102)

202

201

**Fig. 8**

(1021)

204

202

201

**Fig. 9**

(1022)

2041

204

202

201

**Fig. 10**

(103)

204
202
201

**Fig. 11**

(1031)

2042
2021
201

**Fig. 12**

(104)

203
2021
2042
201

**Fig. 13**

(105)

2042

2021

203

2022

201

402    401

**Fig. 14**

300

101

102

1021

1022

103

1031

104

105

**Fig. 15**

**Fig. 16**

**Fig. 17**

**Fig. 18**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20810265967 A1
- US 20180269057 A1
- US 20160005749 A1
- US 20180358471 A1
- WO 2010035980 A2
- CN 103165172 B